# EUROPEAN PATENT SPECIFICATION

(11) **EP 1 461 286 B1**
(45) Date of publication and mention of the grant of the patent: **08.08.2007**
(21) Application number: 02716555.4
(22) Date of filing: 02.05.2002
(51) Int. Cl.: B81B 3/00, B81C 1/00, C30B 29/68, H01L 21/20, C30B 23/02, C23C 14/06, C23C 14/02

(54) **DIFFERENTIAL STRESS REDUCTION IN THIN FILMS**
DIFFERENTIALSPANNUNGSVERMINDERUNG IN DÜNNFILMEN
REDUCTION DE LA CONTRAINTE DIFFERENTIELLE DANS DES FILMS MINCES

(30) Priority: 30.11.2001 AU 2001009197
(43) Date of publication of application: 29.09.2004
(73) Proprietor: Silverbrook Research Pty. Limited, Balmain, NSW 2041 (AU)
(72) Inventor: SILVERBROOK, Kia Silverbrook Research Pty Ltd, Balmain, New South Wales 2041 (AU)
(74) Representative: McCarthy, Denis Alexis
(86) International application number: PCT/AU2002/000537
(87) International publication number: WO 2003/045836

(56) References cited:
- EP-A- 0 455 526
- EP-A- 0 735 586
- WO-A-01/08225
- US-A- 6 087 726
- US-A- 6 114 198
- PATENT ABSTRACTS OF JAPAN & JP 61 225 816 A (SHARP CORP) 07 October 1986
- PATENT ABSTRACTS OF JAPAN & JP 02 266 516 A (HITACHI CABLE LTD) 31 October 1990

## Description

### FIELD OF THE INVENTION

The present invention relates to a method of manufacture of crystalline thin film structures having reduced differential stress build up, and to the crystalline thin film structures that result from the application of this method.

The invention has been developed primarily for use in the manufacture of micro-electro mechanical systems (MEMS) formed using CMOS semiconductor chip technology from materials suited to this particular manufacturing process, and will be described hereinafter with reference to this preferred application. However, it will be appreciated by those skilled in the art, that the invention may be applied to other thin film structures where it is similarly desirable to reduce differential stress levels within the thin film structure.

### BACKGROUND OF THE INVENTION

Processes for the construction of micro-electro mechanical systems (MEMS) are characterised by the formation of micro actuator devices and mechanisms in multi layered wafer structures. Often these layers comprise thin films of different materials having different properties. For example, some of the layers may be required to be conductive, such as where the mechanism includes a heating element as may be used with a thermal bend actuator or the like.

Thin film structures of this kind are typically formed as a wafer using a molecular deposition process such as "sputtering" which causes the requisite material to be deposited at a molecular level until the desired layer thickness has been attained. With these deposition processes, the first layer of material typically forms small seed crystals which adhere to and align themselves with the supporting substrate. However, subsequent deposited material tends to self align on top of these seed crystals and because of the restraint placed on the development of the growing crystals by the substrate and adjacent crystals, further deposition of the same material tends to thus form columnar crystals. Unfortunately, the columnar crystals and the underlayer of small seed crystals have quite different thermal expansion properties and other physical characteristics. With many materials, the growing layer also exhibits progressively expanding crystals during deposition due to the dominant growth of some columnar crystals over others. As a result, certain crystal boundaries exist through the entire thickness of the film, these particular boundaries not only weaken the overall structure, but also representing potential locations for the onset of crack propagation.

As a result of this natural film building process, residual stress is induced into the material during wafer cooling. This can have several undesirable effects. Firstly, the residual stress gradient maybe sufficient to cause a flap beam actuator formed by this process to curl, even though its design is such that it is effectively a clamped or free beam. This may necessitate a re-design of the structure to include additional stiffening elements to counteract any inclination to curl and as a result is highly likely during operation to require additional power to operate the actuator to overcome either the residual stress or the additional resistance caused by the need to stiffen the structural design.

A common method of reducing stress in thin films is annealing. However, for many crystalline thin films, this requires high temperatures which may be incompatible with the device structure or previous processing steps. For example, if a crystalline thin film is deposited on an integrated circuit with aluminium, wiring, then the temperature must remain below the melting point of aluminium, which is too low to anneal many crystalline materials typically used in integrated circuits made using CMOS techniques.

It is an object of the invention to provide a method and structure to reduce the differential stress formed in thin film structures of this kind so as to overcome or at least ameliorate these disadvantages of the prior art, or at least offer a useful alternative.

### SUMMARY OF THE INVENTION

According to a first aspect of the invention, there is provided use of a composite crystalline thin film structure, having a predominant first crystalline material, for reducing a differential stress profile of a comparative film formed solely from said predominant first crystalline material, said composite crystalline thin film structure comprising:
a first and second sub-layer of said predominant first crystalline material; and
a layer of a second crystalline material between said first crystalline material sub-layers,
wherein a lattice constant of said second crystalline material differs from a lattice constant of said first crystalline material.

According to a second aspect of the invention, there is provided a method of manufacture of a crystalline thin film structure from a predominant first crystalline material, said method including the steps of:
depositing said predominant first crystalline material as two or more sub-layers; and
depositing between said first crystalline material sub-layers, a layer of second crystalline material, said second material having a lattice constant that is different from that of the first crystalline material, characterized in that the predominant first material is titanium nitride and the second material is tantalum nitride.

According to a third aspect, the present invention provides a crystalline thin film structure including a first and second layer of a predominant first crystalline material; and
a second crystalline material between the first and second layers wherein,
a lattice constant of the second crystalline material differs from a lattice constant of the predominant first crystalline material
characterized in that the predominant first material is titanium nitride and the second material is tantalum nitride.

While the final total internal stress present in a thin film structure manufactured in accordance with the invention may be higher than may be achieved when annealing can be used, the differential stress is much reduced and the curl tendency of a released layer can be reduced by orders of magnitude.

Preferably, the crystalline thin film structure is a layer of a MEMS structure and more preferably an operational or active layer of a MEMS structure.

Desirably, the second material is selected to have appropriately compatible physical properties relevant to the intended application, as well as possessing a lattice constant that is different from that of the predominant first layer. Where the relevant physical properties of the two materials are similar, such as electrical or thermal conductivity, the thickness of the second material layer relative to the first material sub-layers is less significant. However, where the differences are more pronounced, it is preferable to have a very thin intermediate second material layer so as to minimise the impact of the property difference between the two materials on the final composite structure. Naturally, the pairing of the first and second materials must enable production of a thin film structure having relevant key properties or characteristics that are close to that of the selected predominant first crystalline material.

A preferred combination of first and second crystalline materials, particularly suited for use in MEMS structures incorporating thermal bend actuators is:
titanium nitride as a predominant first material with intermediate layers of tantalum nitride.

This combination is particularly suitable for MEMS constructions formed on top of CMOS circuitry.

### BRIEF DESCRIPTION OF THE DRAWINGS

A preferred embodiment of the invention will now be described, by way of example only, with reference to the accompanying drawings in which:
Figure 1 shows an enlarged partial cross-section of a thin film formed in accordance with the prior art techniques;
Figure 2 shows a length of the thin film of Figure 1 deforming under the residual differential stress;
Figure 3 shows a series of clamped/free thin film strips formed in accordance with the prior art techniques;
Figure 4 shows a partial cross-section through a thin film formed in accordance with the present invention;
Figure 5 shows the crystal boundarys between the primary and secondary layers of the film shown in Figure 4;
Figure 6 shows a thin film formed in accordance with the present invention where the deposition of the primary material has been re-seeded three times; and
Figure 7 shows clamped/free end strips of thin film formed in accordance with the present invention.

### DESCRIPTION OF PREFERRED AND OTHER EMBODIMENTS

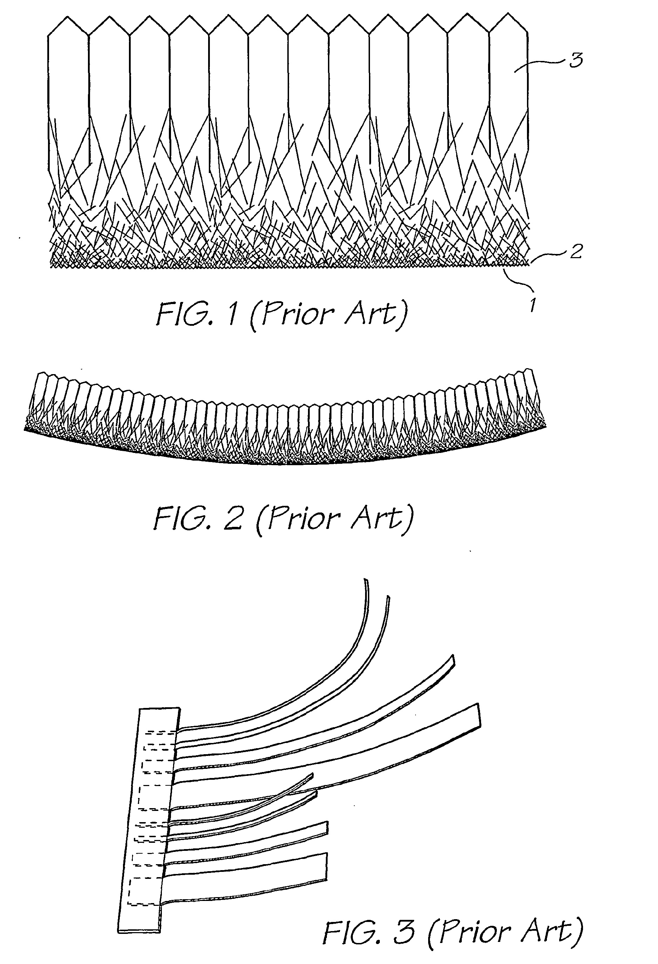

Referring first to figure 1, there is shown a partial cross-section of a titanium nitride layer showing the grain morphology. The layer has been built up from a first side 1 on a substrate composed of silicon with a thin silicon nitrate coating (not shown). As can be seen, the titanium nitride builds up gradually on the silicon nitrate surface commencing with a thin layer 2 of small seed crystals which gradually evolve into larger columnar crystals shown generally at 3. These columnar crystals tend to become progressively larger during deposition due to the dominant growth of some columnar crystals over others. Thus, certain crystal boundaries exist through the entire thickness of the titanium nitride layer. These particular boundaries weaken the titanium nitride layer and would be the likely location for the onset of crack propagation.

The differing thermal conductivity and expansion characteristics of the different portions of the titanium nitride layer induce residual stress in the wafer during cooling. As shown in Figure 2, this residual stress gradient through the layer thickness tends to cause the layer to curl. This can adversely affect the function of MEMS devices formed from the wafer. In particular, thermoelastic actuators in the form of clamped/free end strips are susceptible to a relatively high degree of curl. As shown in Figure 3, a series of clamped/free end beam thin titanium nitride strips are shown. The longer and thinner strips deflect the most however because of the residual compression on the underside of the strips and residual tension on the upper side each strip will tend to curl about it's longitudinal axis as well as lateral axis. Wider strips will curl about the longitudinal axis to produce a deeper lateral cross-section which gives the strip a greater bending stiffness about the lateral axis.

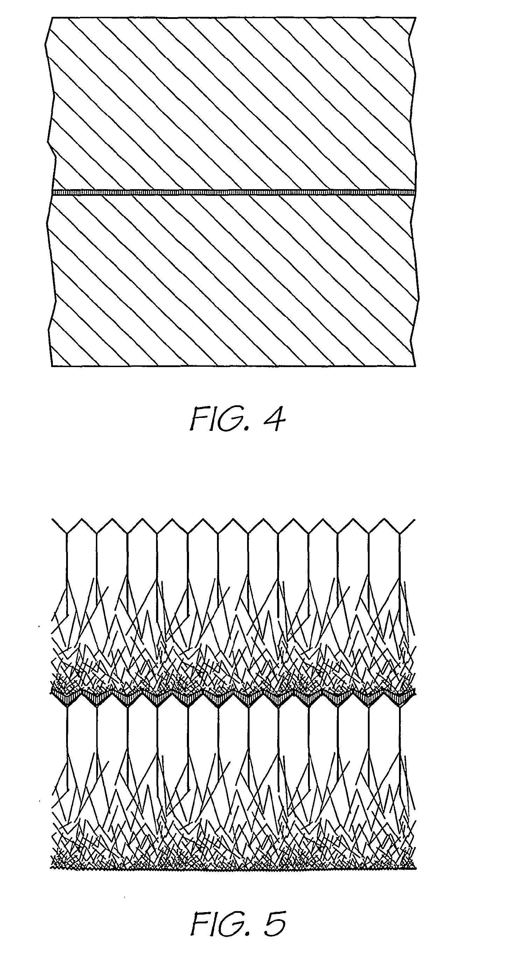

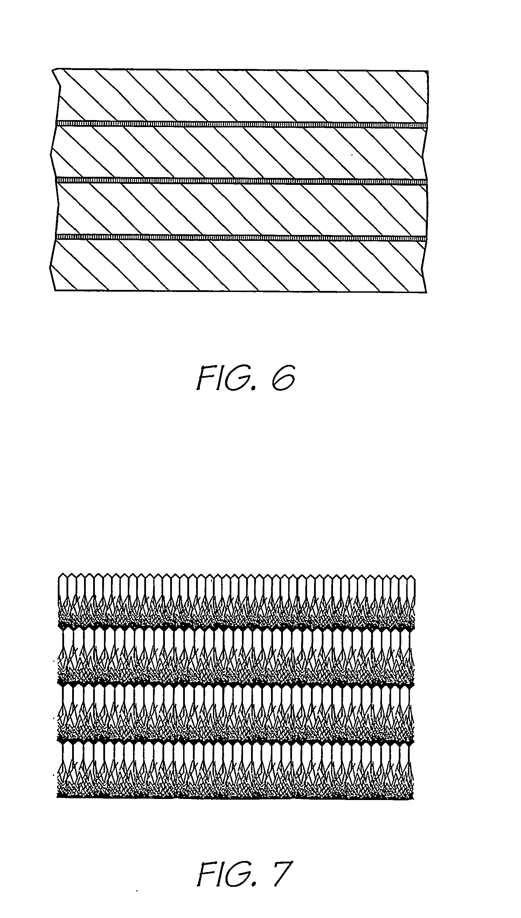

A proposed solution for alleviating this differential stress problem, is shown in Figures 4 to 7. An extremely thin layer (e.g. 10 nanometres (100 Angstroms)) of tantalum nitride is deposited on top of the titanium nitride at certain levels during the deposition of the titanium nitride layer. The tantalum nitride disrupts any predominant titanium nitride columnar crystal growth and provides a new re-seeding layer. The tantalum nitride effectively acts as a crack inhibitor because the maximum titanium nitride grain boundary can only exist between any two tantalum nitride layers.

The presence of the tantalum nitride layers also effectively moderates the range of grain sizes present. Thus, the magnitude of any induced stress gradient related to the grain size is also moderated. This effectively reduces post fabrication curl.

In this particular preferred embodiment, it is important to note that the tantalum layer is thin enough not to affect the mechanical or resistive properties of the actuator. Tantalum nitride has a decomposition temperature of 750 degrees Centigrade which is above that of titanium nitride.

### Examples

A finite element model of a simple beam suitable for use in a thermal bend actuator was constructed to investigate residual curl of the tantalum nitride/titanium nitride layer structure. The intent of the analysis was to ascertain the relative effect that different morphologies have on residual curl rather than the calculation of absolute values. The beam model has identical dimensions to the heater section of a centreline prototype thermal actuator and was constructed with ten elements through the thickness. A stress gradient was indirectly included by applying a linearly varying temperature field through the entire thickness. The presence of a tantalum nitride layer is modelled by reapplying the gradient from the initial value.

Four different layer combinations were analysed including no tantalum nitride re-seeding layer, and one, two and four layers of tantalum nitride. The solutions resulted in deflections at the beam tip of 0.543, 0.0611, 0.0172 and 0.001 micrometres respectively. It should be noted that these values are relative and not absolute.

The results of the tests show that the inclusion of tantalum nitride layers can significantly reduce the amount of post-fabrication curl by progressive orders of magnitude depending on the desired overall thickness, number of intermediate layers and the thickness of those intermediate layers.

The above described examples relate to a specific conductor layer having titanium nitride as the predominant material with intermediate layers of tantalum nitride.

Accordingly, while the invention has been described with reference to only one use and a preferred combination, it will be appreciated by those skilled in the art that the invention can be embodied in many other forms and the scope of the invention is as defined by the appended claims.

## Claims

1. Use of a composite crystalline thin film structure, having a predominant first crystalline material, for reducing a differential stress profile of a comparative film formed solely from said predominant first crystalline material, said composite crystalline thin film structure comprising:
a first and second sub-layer of said predominant first crystalline material; and
a layer of a second crystalline material between said first crystalline material sub-layers,
wherein a lattice constant of said second crystalline material differs from a lattice constant of said first crystalline material.

2. A method of manufacture of a crystalline thin film structure from a predominant first crystalline material, said method including the steps of:
depositing said predominant first crystalline material as two or more sub-layers; and
depositing between said first crystalline material sub-layers, a layer of second crystalline material, said second material having a lattice constant that is different from that of the first crystalline material,
**characterized in that** the predominant first material is titanium nitride and the second material is tantalum nitride.

3. A crystalline thin film structure including a first and second layer of a predominant first crystalline material; and
a second crystalline material between the first and second layers wherein,
a lattice constant of the second crystalline material differs from a lattice constant of the predominant first crystalline material
**characterized in that** the predominant first material is titanium nitride and the second material is tantalum nitride.

4. A use, a method or a crystalline thin film structure according to any one of the preceding claims, wherein the structure is a layer of a MEMS structure.

5. A use, a method or a crystalline thin film structure according to claim 4 wherein the structure is an operational ann in a thermo elastic actuator.

6. A use, a method or a crystalline thin film structure according to any one of the preceding claims, wherein the film thickness is less than 500 nanometres.

7. A use, a method or a crystalline thin film structure according to any one of the preceding claims, wherein the structure has more than two layers of predominant first crystalline material, and wherein a layer of the second crystalline material is interleaved between each adjacent layer of the first predominant crystalline material.

8. A use, a method or a crystalline thin film structure according to claim 7, wherein the structure has four layers of the predominant first crystalline material and three layers of the second crystalline material interleaved between each adjacent layer of the predominant first crystalline material.

9. A use, a method or a crystalline thin film structure according to claim 7 wherein the thickness of the structure is about 300 nanometres and the thickness of each of the layers of predominant first crystalline material is about 70 nanometres and the thickness of the second crystalline material is about 10 nanometres each.

## Patentansprüche

1. Verwendung einer kristallinen Dünnfilm-Verbundstruktur, die ein überwiegendes erstes Material zur Verminderung eines Differentialspannungsprofils eines Vergleichsfilms, der lediglich aus dem überwiegenden ersten kristallinen Material gebildet ist, aufweist, wobei die kristalline Dünnfilm-Verbundstruktur umfasst :
eine erste und eine zweite Teilschicht aus besagtem überwiegendem ersten kristallinen Material ; und
eine Schicht eines zweiten kristallinen Materials zwischen den ersten Teilschichten aus kristallinem Material,
wobei eine Gitterkonstante des zweiten kristallinen Materials sich von einer Gitterkonstante des ersten kristallinen Materials unterscheidet.

2. Verfahren zur Herstellung einer kristallinen Dünnfilmstruktur aus einem überwiegenden ersten kristallinen Material, wobei das Verfahren die Schritte umfasst des :
Anbringens des überwiegenden ersten kristallinen Materials als zwei oder mehr Teilschichten ; und
Anbringens einer Schicht zweiten kristallinen Materials zwischen den ersten Teilschichten aus kristallinem Material, wobei das zweite Material eine Gitterkonstante aufweist, die sich von der des ersten kristallinen Materials unterscheidet,
**dadurch gekennzeichnet, dass** das überwiegende erste Material Titannitrid ist und das zweite Material Tantalnitrid ist.

3. Kristalline Dünnfilmstruktur, welche eine erste und eine zweite Schicht eines überwiegenden ersten kristallinen Materials beinhaltet ; und
ein zweites kristallines Material zwischen der ersten und der zweiten Schicht, wobei
eine Gitterkonstante des zweiten kristallinen Materials sich von einer Gitterkonstante des überwiegenden ersten kristallinen Materials unterscheidet,
**dadurch gekennzeichnet, dass** das überwiegende erste Material Titannitrid ist und das zweite Material Tantalnitrid ist.

4. Verwendung, Verfahren oder kristalline Dünnfilmstruktur gemäß einem der vorgenannten Ansprüche, wobei die Struktur eine Schicht einer MEMS-Struktur ist.

5. Verwendung, Verfahren oder kristalline Dünnfilmstruktur gemäß Anspruch 4, wobei die Struktur ein Funktionsarm in einem thermoelastischen Betätigungselement ist.

6. Verwendung, Verfahren oder kristalline Dünnfilmstruktur gemäß einem der vorgenannten Ansprüche, wobei die Filmdicke weniger als 500 Nanometer beträgt.

7. Verwendung, Verfahren oder kristalline Dünnfilmstruktur gemäß einem der vorgenannten Ansprüche, wobei die Struktur mehr als zwei Schichten überwiegenden ersten kristallinen Materials aufweist, und wobei eine Schicht des zweiten kristallinen Materials zwischen jede benachbarte Schicht des ersten überwiegenden kristallinen Materials eingelegt ist.

8. Verwendung, Verfahren oder kristalline Dünnfilmstruktur gemäß Anspruch 7, wobei die Struktur vier Schichten des überwiegenden ersten kristallinen Materials aufweist und drei Schichten des zweiten kristallinen Materials zwischen jede benachbarte Schicht des überwiegenden ersten kristallinen Materials eingelegt aufweist.

9. Verwendung, Verfahren oder kristalline Dünnfilmstruktur gemäß Anspruch 7, wobei die Dicke der Struktur etwa 300 Nanometer beträgt und die Dicke jeder der Schichten überwiegenden ersten kristallinen Materials etwa 70 Nanometer beträgt und die Dicke des zweiten kristallinen Materials jeweils etwa 10 Nanometer beträgt.

## Revendications

1. Utilisation d'une structure cristalline composite en film mince possédant une première matière cristalline principale, pour réduire le profil de contraintes différentielles d'un film comparable constitué uniquement de ladite première matière cristalline principale, ladite structure cristalline composite en film mince comprenant :
une première et une deuxième sous-couche de ladite première matière cristalline principale ; et
une couche d'une deuxième matière cristalline entre lesdites premières sous-couches de matière cristalline,
la constante du réseau cristallin de ladite deuxième matière cristalline différant de la constante du réseau cristallin de ladite première matière cristalline.

2. Procédé de fabrication d'une structure cristalline en film mince à partir d'une première matière cristalline principale, ledit procédé englobant les étapes consistant à :
déposer ladite première matière cristalline principale sous la forme de deux sous-couches ou plus ;
déposer entre lesdites premières sous-couches de matière cristalline, une couche constituée d'une deuxième matière cristalline, ladite deuxième matière possédant une constante de réseau cristallin qui est différente de celle de la première matière cristalline,
**caractérisé en ce que** la première matière principale et du nitrure de titane et la deuxième matière est du nitrure de tantale.

3. Structure cristalline en film mince englobant une première et une deuxième couche d'une première matière cristalline principale ; et
une deuxième matière cristalline entre la première et la deuxième couche,
la constante du réseau cristallin de la deuxième matière cristalline différant de la constante du réseau cristallin de la première matière cristalline principale,
**caractérisée en ce que** la première matière principale est du nitrure de titane et la deuxième matière est du nitrure de tantale.

4. Utilisation, procédé ou structure cristalline en film mince selon l'une quelconque des revendications précédentes, dans lequel/laquelle la structure est une couche constituée d'une structure MEMS.

5. Utilisation, procédé ou structure cristalline en film mince selon la revendication 4, dans lequel/laquelle la structure est un bras opérationnel dans un actionneur thermo-élastique.

6. Utilisation, procédé ou structure cristalline en film mince selon l'une quelconque des revendications précédentes, dans lequel/laquelle l'épaisseur du film est inférieure à 500 nm.

7. Utilisation, procédé ou structure cristalline en film mince selon l'une quelconque des revendications précédentes, dans lequel/laquelle la structure possède plus de deux couches constituées de la première matière cristalline principale, et dans lequel/laquelle la couche de la deuxième matière cristalline est intercalée entre chaque couche adjacente de la première matière cristalline principale.

8. Utilisation, procédé ou structure cristalline en film mince selon la revendication 7, dans lequel/laquelle la structure possède quatre couches constituées de la première matière cristalline principale et trois couches constituées de la deuxième matière cristalline intercalée entre chaque couche adjacente de la première matière cristalline principale.

9. Utilisation, procédé ou structure cristalline en film mince selon la revendication 7, dans lequel/laquelle l'épaisseur de la structure s'élève à environ 300 nm et l'épaisseur de chacune des couches de la première matière cristalline principale s'élève à environ 70 nm, l'épaisseur respective de la deuxième matière cristalline s'élevant à environ 10 nm.
